# EUROPEAN PATENT APPLICATION

(11) **EP 4 838 237 A1**
(43) Date of publication of application: **11.11.2026**
(21) Application number: 25382452.8
(22) Date of filing: 05.05.2025
(51) Int. Cl.: G01R 31/367, G01R 31/389, G01R 31/392

(54) **A MODEL-BASED METHOD TO DETERMINE, INTER ALIA, THE BEST AND WORST STATES OF BATTERY HEALTH IN THE BATTERY SYSTEM**

(71) Applicant: Hitachi Energy Ltd, 8050 Zürich (CH)
(72) Inventor: LIU, Lu, 100044 Beijing (CN); JIANG, Wen, 102218 Beijing (CN); LUGARO DUELO, Jesus Juan, 28037 Madrid (ES); LEI, Yu, 100083 Beijing (CN); YANG, XiaoBo, 100015 Beijing (CN); SU, CuiCui, 102200 Beijing (CN); WANG, Yang, 100077 Beijing (CN); OCIO VIERNA, Oscar, 28010 Madrid (ES)
(74) Representative: Vossius & Partner Patentanwälte Rechtsanwälte mbB

(57) **Abstract**

The disclosure provides a method for determining a measure of degradation of state of health, SOH, of a battery energy storage system, BESS, comprising a plurality of battery cells, the method comprising: determining a plurality of sets of electrical equivalent circuit model, ECM, parameters for the plurality of corresponding battery cells; determining a first temperature at the BESS and a second temperature at the BESS; determine a first SOH of an ECM based on a first set of ECM parameters derived from the plurality of sets of ECM parameters , and one of the first temperature and the second temperature; determine a second SOH of the ECM based on a second set of ECM parameters derived from the plurality of sets of ECM parameters , and one of the first temperature and the second temperature; determining the measure of degradation of the SOH of the BESS based on the first SOH and the second SOH.

## Description

The present disclosure relates to a method for determining a measure of degradation of state of health (SOH) of a battery energy storage system (BESS) comprising a plurality of battery cells, a computer program to execute the method, and a system for implementing the method.

Estimation of a state of health (SOH) for a battery system (modules, pack, rack, BESS) is essential to address the safety concerns and the efficient utilization of the battery. However, a battery system contains hundreds of batteries, which have inherent inconsistency because of slight deviations and uncertain factors in their production process. There is no standard method to estimate the state of health of batteries in systems like battery modules, and battery racks.

In applications, several hundreds of battery cells are connected in series or parallel to form a battery pack/rack to meet the power requirements. The utilization efficiency and safe operation of battery systems depend on the SOH of each battery cells. Thus, precise estimation of battery cells' aging levels is necessary. However, the inconsistency of batteries makes it difficult to estimate the health state within a battery system.

The known technology shows disadvantages as for example unprecise prediction, high computational load, and more.

The above-mentioned disadvantages are at least partly overcome and/or advantages mentioned herein are at least partly achieved with the features of the independent claims. Dependent claims define preferred embodiments of the present disclosure.

The present disclosure shows a method for determining a measure of degradation of state of health (SOH) of a battery energy storage system (BESS) comprising a plurality of battery cells, a computer program to execute the method, and a system for implementing the method.

The present disclosure relates to a method for determining a measure of degradation of state of health (SOH) of a battery energy storage system (BESS) comprising a plurality of battery cells, the method comprising: determining a plurality of sets of electrical equivalent circuit model (ECM) parameters for the plurality of corresponding battery cells; determining a first temperature at the BESS and a second temperature at the BESS; determine a first SOH of an ECM based on a first set of ECM parameters derived from the plurality of sets of ECM parameters, and one of the first temperature and the second temperature; determine a second SOH of the ECM based on a second set of ECM parameters derived from the plurality of sets of ECM parameters, and one of the first temperature and the second temperature; determining the measure of degradation of the SOH of the BESS based on the first SOH and the second SOH.

State of health (SOH) may be capacity state of health or energy state of health. SOH may be the state of health of a battery cell or BESS. The SOH can be determined by comparing the remaining capacity/energy/internal resistance of the battery to its initial capacity/energy/internal resistance.

The model-based method can employ theoretical knowledge and experience to build battery system models, such as battery system ECM models and empirical degradation models for SOH estimation. An ECM can describe the direct relationship between the electrochemical phenomena in the battery and the circuit elements. The electrical behaviors of battery cells can be simulated. The ECM may be constructed on the basis of open-circuit voltage curves (OCV) and equivalent circuit/ECM parameters.

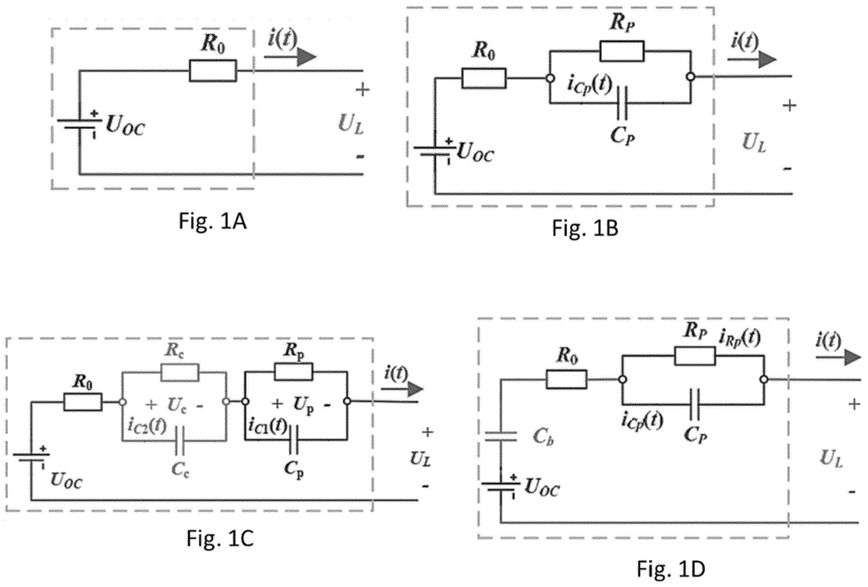

The ECM may be the Rint model, Thevenin model, PNGV model, GNL model, second-order RC model or some enhanced ECM models. The ECM model is based on the set of ECM parameter. In the example of the RC ECM model, the 2-RC ECM model requires 6 ECM parameters including OCV, R0, R1, R2, C1 and C2 (or tau1 and tau2) making up a set of ECM parameters (see also description of fig. 1 and following, disclosed below). The inconsistency of battery cells will cause the variety of values of the six parameters through different sets of the ECM parameters, thus leading to different simulation results of electrical behaviors like battery voltages, power, and state of charge (SOC). Different electrical behaviors will directly affect the simulated aging speed of battery cells. Therefore, to accurately estimate the degradation of battery cells using a model-based method, an efficient combination of ECM parameters is advantageous.

The disclosed method uses two sets of ECM parameters (first and second set), representing two units where each unit is one ECM. The plurality of sets of ECM parameters may represent the plurality of battery cells - each set of the plurality of sets of ECM parameters corresponding to one battery cell of the plurality of battery cells. Preferably, no further sets of ECM parameters are used to calculate the measure of degradation of the SOH of the BESS. Similarly, no further temperatures, other than the first and second temperature, may be used. This may limit the amount of data to be processed and hence reduces computational load.

The scope of the above disclosed method may be such that the first SOH and the second SOH may be interchangeable in at least some embodiments.

Determining may comprise one or more of measuring, simulating, calculating and other. Determining the plurality of ECM parameters may comprise measuring at each battery cell and/or the BESS. Determining the temperatures may comprise measuring the temperature or may comprise simulating the BESS or obtaining it from the BMS (battery management system). Determining the first and second SOH may comprise simulating and/or calculating. Determining the second SOH may happen after or simultaneous or partially temporally overlapping with determining the first SOH. Determining the measure of degradation of the SOH may comprise calculating.

The BESS may be a system of a plurality of battery cells, preferably connected in parallel or in series to each other. The BESS may be a module, a pack, or a rack. The battery cells may be Li(lithium)-ion batteries, Sodium-ion batteries, and/or other batteries on which ECM may be used to simulation the electrical behavior.

The disclosed method may require only little computation. It may cover all battery inconsistencies to improve the determined SOH accuracy.

Preferably, the first SOH is a minimum SOH, the second SOH is a maximum SOH, the first temperature is a minimum temperature and the second temperature is a maximum temperature.

The terms "minimum" and "maximum", for example for SOH and temperature, may refer to the global minimum and global maximum or, in other embodiments, refer to some values near the minimum and maximum, respectively. The minimum temperature and the maximum temperature may refer to temperatures at the BESS. This may be a temperature inside the BESS, at a battery cell of the BESS, at the geometrical center of the BESS, and/or the like.

Some embodiments are a modeling method for accurately estimating the best and worst case of SOH in the BESS. In such a battery modeling method, the maximum and minimum values of ECM parameters may be effectively combined to simulate inconsistencies in the electrical behavior of batteries. Then, by combining with minimum and maximum temperatures as inputs, the best and worst health states of the battery may be simulated in the battery system. This modeling approach considers the two most extreme parameters and therefore it can provide a reference range or another measure of degradation for the state of health of the BESS.

The ECM in this method may be embedded with effective combination of sets of maximum and minimum ECM parameters. So, the model can simulate the boundary values of inconsistent electrical behaviors for a battery system.

To obtain the minimum and maximum values of each ECM parameters, the direct method may select the minimum and maximum values from all the values, and another method is to obtain the distribution of all the values and define the minimum and maximum values according to the distribution law.

In some embodiments, the first SOH is smaller than the second SOH; and/or the first SOH may be below an average SOH and the second SOH above an average SOH. In these embodiments, the first set of ECM parameters deteriorates the SOH stronger than the second set of ECM parameters, and the one of the first and second temperature used to determine the first SOH deteriorates the SOH more than the other one of the first and second temperatures used to determine the second SOH. While these values may not be the minimum and maximum values of SOH, ECM parameters and temperature, they may still result in a representative measure of degradation of the SOH of the BESS. Due to statistical distribution, the first SOH and second SOH will likely be distributed in a representable manner. At the same time, it is not necessary to compare many different values for ECM parameters and temperatures. This reduces computation.

Preferably, the minimum temperature is a simulated lowest temperature at the BESS, a lowest temperature measured at the BESS or an average of a predefined number of strongest local minimum values of the temperature at the BESS, and wherein the maximum temperature is a simulated highest temperature at the BESS, a highest temperature measured at the BESS or an average of the predefined number of strongest local maximum values of the temperature at the BESS.

The predefined number of strongest local minimum/maximum values of the temperature at the BESS may be a number like 3, 5, 10, or different. The strongest minimum/maximum may be the most extreme local minimum/maximum.

Preferably, determining the minimum SOH is based on the first set of ECM parameters derived from the plurality of sets of ECM parameters minimizing the SOH and one of the minimum temperature and the maximum temperature which minimizes the SOH; and wherein determining the maximum SOH is based on the second set of ECM parameters derived from the plurality of sets of ECM parameters maximizing the SOH and one of the minimum temperature and the maximum temperature which maximizes the SOH.

Preferably, each ECM parameter of the first set of ECM parameters deteriorates an SOH more than a corresponding ECM parameter rating of one of the plurality of battery cells; and wherein each ECM parameter of the second set of ECM parameters deteriorates an SOH less than a corresponding ECM parameter rating of one of the plurality of battery cells;

Preferably, the first SOH is an SOH in a lower range of x% and the second SOH is an SOH in an upper range of x%, wherein 0 < x < 50.

The value x may be 5, 10, 15, 20, 25, or another value. The corresponding first and second sets of ECM parameters and first and second temperature may be determined by being in the lower or upper range of x%, respectively. In this manner, not all values for the ECM parameters and temperatures have to be determined and/or compared. It can be statistically determined that only a part of the values need to be determined and/or compared to have a value in the lower/upper range of x%. This reduces computation.

Preferably, the first temperature is a temperature in an upper range of x% of temperatures at the BESS, and the second temperature is a temperature in a lower range of x% of temperatures at the BESS.

This value x is the same as the value x above for the range of SOH. In some embodiments, another value y than x may be used for the range (y%) of temperatures, with 0 < y < 50. The value y may be 5, 10, 15, 20, 25, or another value.

Preferably, the measure of degradation is determined based on only the first SOH and the second SOH.

The measure of degradation may be a range, a standard deviation, an average, the smaller one of the first and second SOH, or different. In case of a range, the range may be the range between the first and second SOH. In case of a standard deviation, the standard deviation may represent one standard deviation of a normed distribution. This may be preferably, when the first and second values of ECM parameters and/or temperatures are not global minimum and global maximum. In case of an average, it may be the average of the first and second SOH.

Preferably, the measure of degradation of the SOH of the BESS is a range of the SOH of the plurality of battery cells or an average of the SOH of the plurality of battery cells.

Preferably, the first set of ECM parameters and the second set of ECM parameters are comprised by the plurality of sets of ECM parameters.

This may mean that the first set of ECM parameters and the second set of ECM parameter each describe a different battery cell of the BESS.

Preferably, each of the first set of ECM parameters and the second set of ECM parameters comprise ECM parameters from different sets of ECM parameters of the plurality of sets of ECM parameters.

This may mean that the first set of ECM parameters and the second set of ECM parameter each are assimilated from single ECM parameters independent whether these single ECM parameters correspond to the same or different battery cells. For example, the first set of ECM parameter may comprise a first ECM parameter, for example r of the ohmic resistor (when the ECM model is a second-order RC equivalent circuit model), corresponding to one battery cell and a second parameter, for example the first polarization capacitance Cₚ₁, of another battery cell. Especially in a case where the first SOH is the absolute minimum SOH, and thus the first set of ECM parameter should deteriorate the SOH strongest, the first parameter (deteriorating the SOH strongest from all values of this kind of parameter in the plurality of sets of ECM parameters) may correspond to a different battery cell than the second parameter (which also deteriorating the SOH strongest from all values of this kind of parameter in the plurality of sets of ECM parameters).

Preferably, the ECM parameters comprise different parameters for charging and discharging.

The battery cells may have a hysteresis effect between charging and discharging. Therefore, discharging test and charging test, for determining the ECM parameters, may be performed separately to obtain charging ECM parameters and discharging ECM parameters. The hybrid pulse power characterization (HPPC) test and Galvanostatic intermittent titration technique (GITT) at BESS level can be used to identify ECM parameters. Discharging HPPC and charging GITT testing may be used. Using the 2-RC ECM model as an example, how to identify ECM parameters of R0, R1, R2, taul and tau2 from HPPC and GITT curves. OCV may be close to the cell terminal voltage when the battery is under rest. Thus, terminal voltage of the battery after a rest period in the HPPC or GITT test may be used as OCV.

Determining the first and second SOH may also consider specific charging cycles, including average depth of charge and average state of charge.

Preferably, the second SOH of an ECM and the first SOH of an ECM are determined using an SOH aging model.

The SOH aging model may be a semi-empirical aging function. Another aging model and/or formular that require electrical behaviors and thermal parameters as inputs may be used.

Preferably, the plurality of sets of ECM parameters are determined using hybrid pulse power characterization and/or galvanostatic intermittent titration technique.

Hybrid pulse power characterization (HPPC) is described in Bia 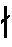 o 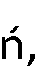 , Tadeusz, et al. "HPPC Test Methodology Using LFP Battery Cell Identification Tests as an Example." Energies 16.17 (2023): 6239. galvanostatic intermittent titration technique (GITT) is described in Kim, Jaeyoung, et al. "Principles and applications of galvanostatic intermittent titration technique for lithium-ion batteries." Journal of Electrochemical Science and Technology 13.1 (2022): 19-31.

For a BESS, hundreds of batteries may be connected in series or parallel. Battery inconsistency exists for the same type of battery due to the inhomogeneities in the production process or raw materials. Therefore, when the HPPC and GITT test or similar tests are conducted for a battery system, the extracted ECM parameters for different batteries can show some differences.

Preferably, the method comprises further: determining a usage time when the SOH of the BESS has deteriorated by a predetermined amount based on the measure of degradation of the SOH.

The predetermined amount of deterioration may be a degradation of 20% (meaning down to 80% of original SOH), or a degradation of 10%, 15%, 25%, 30%, 40%, 50%, or another value. The usage time may be determined when the BESS was newly produced. Then, an average life span of the BESS may be known. This may need fewer calculation capacities. In some embodiments, the usage time and the measure of degradation of SOH may be determined throughout the usage of the BESS. This may include regularly measuring one or more temperatures and accordingly determining a degradation for a corresponding time. In these embodiments, the usage time may be finally determined and known when it has passed. This may be a more exact determination of the usage time. The usage time may also or alternatively be a lifetime, an ageing indicator, and/or RUL (remaining useful life).

Preferably, the method comprises further: exchanging and/or renovating the BESS after the usage time.

The present disclosure also relates to a computer program comprising instructions which, when the computer program is executed by a computer, cause the computer to carry out the disclosed method.

The present disclosure also relates to a computer-readable (storage) medium comprising instructions which, when executed by a computer, cause the computer to carry out the disclosed method.

The present disclosure also relates to a computer program product comprising instructions which, when the program is executed by a computer, cause the computer to carry out the disclosed method.

The present disclosure also relates to a system comprising a data processing apparatus comprising a processor configured to perform the disclosed method and a measurement device; wherein the measurement device is configured to determining the plurality of sets of ECM parameters for the plurality of corresponding battery cells by measuring.

The data processing apparatus may implement the disclosed computer program. The data processing apparatus may be a BMS.

Preferably, the system further comprises the BESS.

Various embodiments may preferably implement the following features.

The described advantages of the aspects are neither limiting nor exclusive to the respective aspects. An aspect might have more advantages, not explicitly mentioned.

The exemplary embodiments disclosed herein are directed to providing features that will become readily apparent by reference to the following description when taken in conjunction with the accompany drawings. In accordance with various embodiments, exemplary systems, methods, devices and computer program products are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

The above and other aspects and their implementations are described in greater detail in the drawings, the descriptions, and the claims.
Figs. 1A to 1D show exemplary ECM models for battery cells.
Fig. 2 shows an exemplary flow chart showing the concept of an exemplary embodiment of the disclosed method.
Fig. 3 shows exemplary current curves of Li-ion batteries according to HPPC (left) and GITT (right).
Fig. 4 shows exemplary tested voltage curves for one battery.
Fig. 5A and 5B show exemplary maximum and minimum values of six ECM parameters.
Fig. 6 shows an exemplary model structure built by Simulink.
Fig. 7 shows one exemplary way to define the work condition by defining current work conditions of a battery.
Fig. 8 show exemplary (from top to bottom) voltage, SOC, and Crate, each over time.
Fig. 9 shows an exemplary graph of temperatures over time.
Fig. 10 shows the exemplary determined minimum SOH and maximum SOH.
Fig. 11 shows an exemplary BESS.
Fig. 12 shows an exemplary flowchart showing the method.

Figs. 1A to 1D show ECM models for battery cells. An ECM can describe the direct relationship between the electrochemical phenomena in the battery and the circuit elements. The electrical behaviors of battery cells can be simulated. The ECM is constructed on the basis of OCV and equivalent circuit parameters. Fig. 1A shows a Rint ECM model. Fig. 1B shows a Thevenin ECM model. Fig. 1C shows a second order RC ECM model. The circuit contains two RC pairs. Thus, the model simulates two time constants of the dynamic model τ1 = R_{c}C_{c}, τ2 = RₚCₚ. Fig. 1D shows a PGVN ECM model. "R" represents a resistor; "C" a capacitor; "U" a voltage; and "i" a current.

In the second order RC ECM model (shown in fig. 1C), the cell terminal voltage can be expressed by the following equations: $U = {U}_{OC} - {iR}_{0} - {iR}_{1} \left(1-{e}^{- \frac{t}{τ 1}}\right) - {iR}_{2} \left(1-{e}^{- \frac{t}{τ 2}}\right)$ ${τ}_{1} = {R}_{1} {C}_{1}$ ${τ}_{2} = {R}_{2} {C}_{2}$

Where, *U_{OC}* is the open-circuit voltage, *τ*₁ is time constant of the 1st RC loop, *τ*₂ is time constant of the 2nd RC loop. *i* is the cell current: i > 0 for discharging and i < 0 for charging. Here, R₁ is R_{c}; R₂ is Rₚ; C₁ is C_{c}; and C₂ is Cₚ.

Based on above equations, the maximum and minimum ECM parameters may be combined reasonably to get the maximum and minimum electrical behaviors (shown in the table below). The electrical model can output the maximum and minimum values of electrical behaviors including but not limited to SOH, efficiency, power loss, power, SOC and voltage.

The table below shows an exemplary input combination of ECM parameters and temperatures:

| | | Cell 1 | Cell 2 |
|---|---|---|---|
| ECM parameters combination | Charging | *U_{ocvmax_ch}, R_{0max_ch}, R*₁*_{max_ch}, R_{2max_ch}, τ*_{1*min_ch*}, *τ*_{2*min_ch*} | *U_{ocvmin_ch}, R*₀*_{min_ch}, R*_{1*min*_}*_{ch}, R*_{2*min_ch*}, *τ*₁*_{max_ch}, τ*_{2*max_ch*} |
| | Discharging | *U_{ocvmin_disch}, R*₁*_{max_disch}, R*₂*_{max_disch}, τ*_{1*min_disch*}, *τ*_{2*min_disch*} | *U_{ocvmax_disch}, R*₀*_{min_disch}, R*₁*_{min_disch}, R*₂*_{min_disch}, τ*₁*_{max_disch}, τ*_{2*max_disch*} |
| Temperature | | Temperature _ max | Temperature _ min |

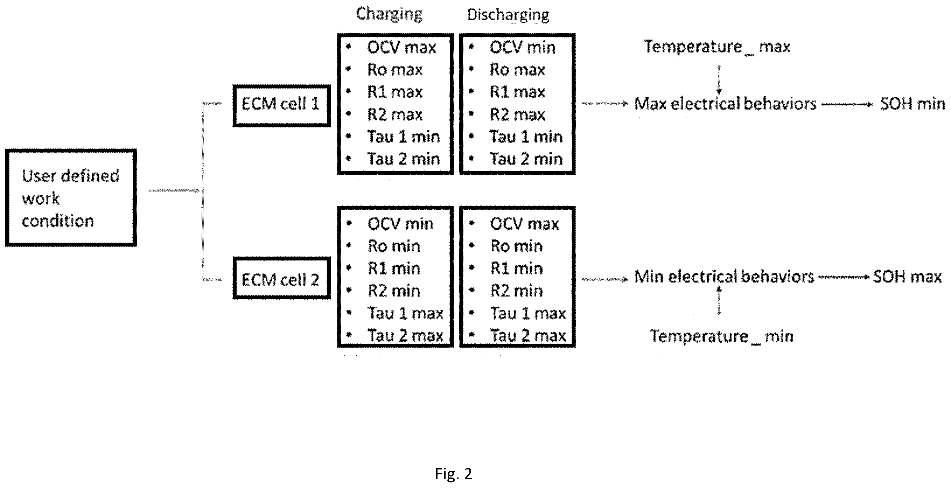

Fig. 2 shows a flow chart showing the concept of an exemplary embodiment of the disclosed method. The model can simulate the maximum and minimum electrical parameters. Using a model, like the battery semi-empirical aging model, the minimum and maximum SOH (examples of first and second SOH) can be calculated.

The flow chart of fig. 2 shows input of the ECM parameters in the form of two sets for the two ECM cells. Each of the two sets comprises different values (for each of the same parameter) for charging and discharging. The ECM parameters used in this example are as of the ECM model used also just above in this description (see table). These sets of ECM parameters are then processed to minimum/maximum electrical behaviors. Together with the minimum/maximum temperature, the sets of ECM parameters are processed to determine the minimum and maximum SOH of the BESS.

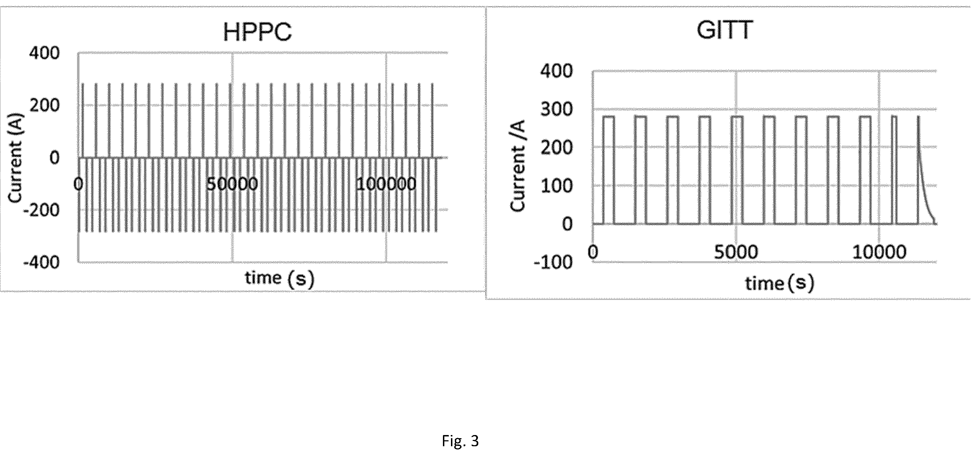

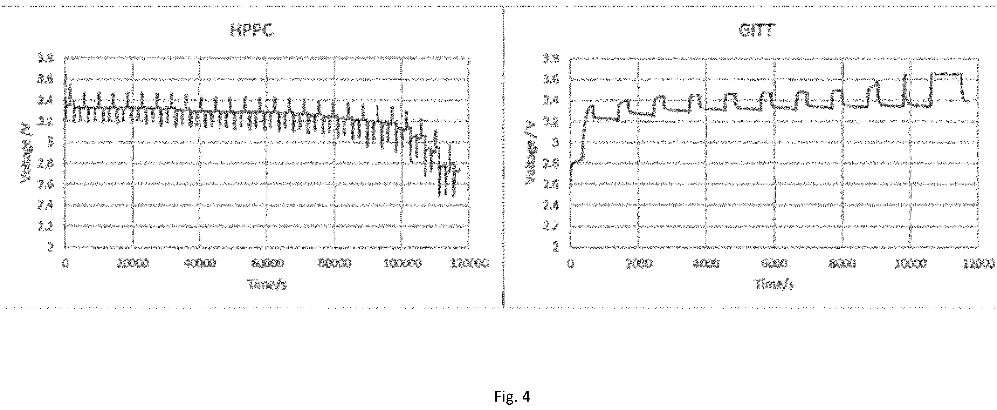

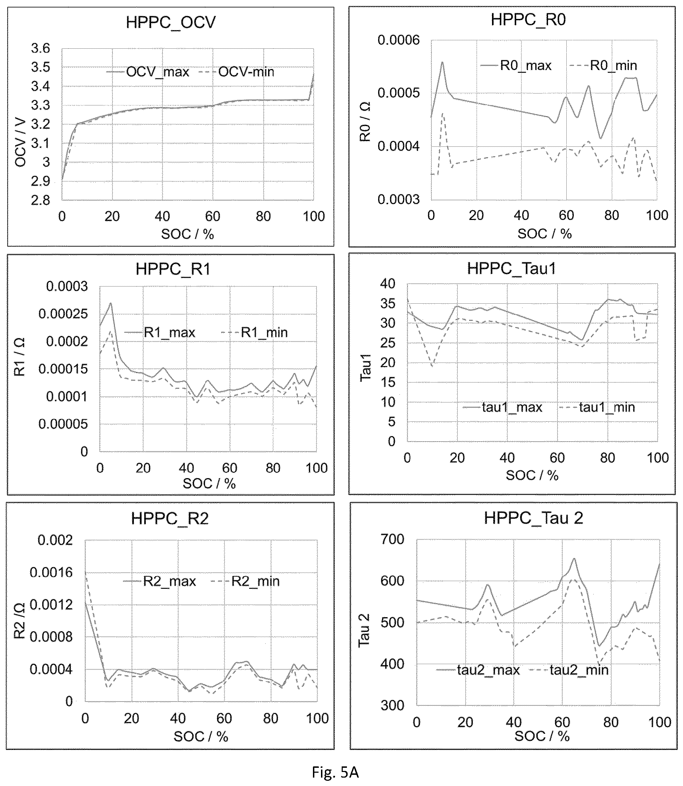

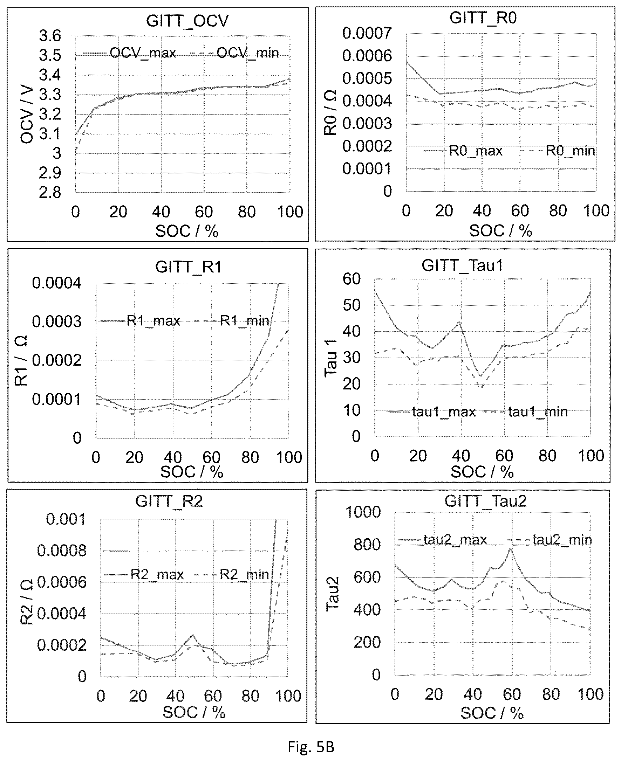

Now disclosed is a working embodiment of the disclosed method in figs. 3 to 10. Fig. 3 shows exemplary current curves of Li-ion batteries according to HPPC (left) and GITT (right). The tested voltage curves for one battery are shown in Figure 4. The ECM parameters of OCV, R0, R1, R2, C1 and C2 (or taul and tau2) can be obtained from the HPPC and GITT test for all batteries. Then the maximum and minimum values are picked out for the six ECM parameters. Figs. 5A and 5B shows maximum and minimum values of the six ECM parameters (OCV, R0, R1, R2, taul and tau2). The model is based on the disclosed framework with two ECM model units embedded in the maximum and minimum values of each set of ECM parameters from Figs 5A and 5B. Each unit is an ECM.

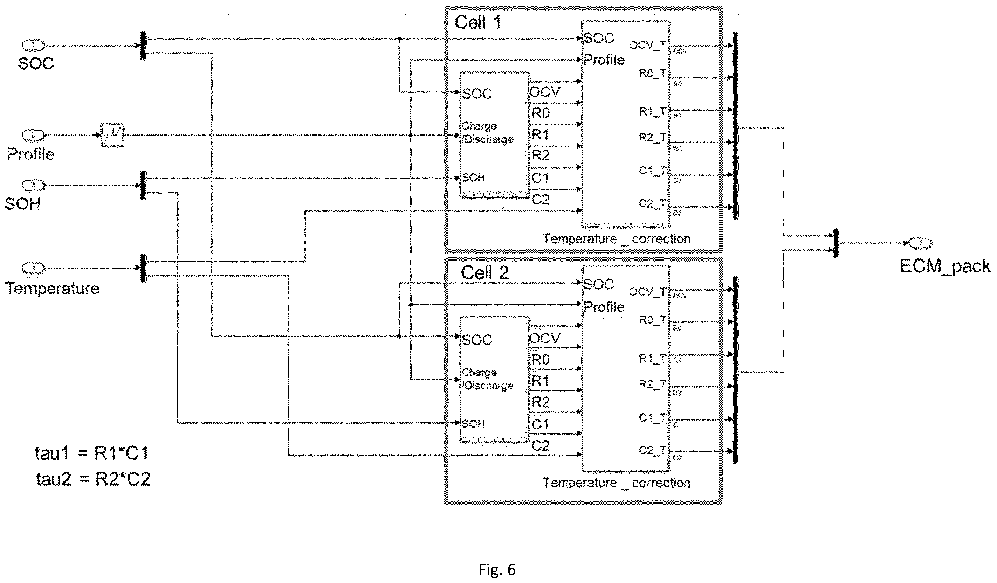

Fig. 6 shows an exemplary model structure built by Simulink. Cell 1 and Cell 2 are assigned with ECM parameter combinations as in the table above respectively.

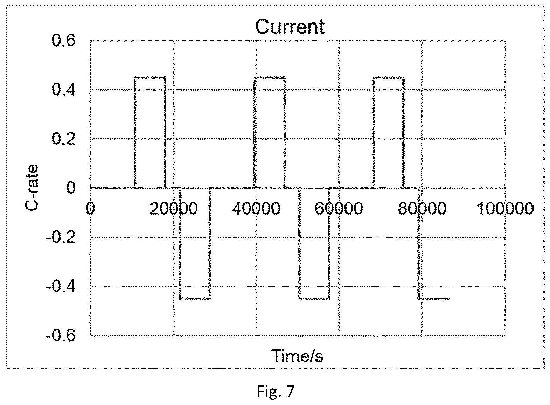

The input for the model is the defined work condition of a battery by users. Fig. 7 shows one way to define the work condition by defining current work conditions of a battery. In some embodiments, the users can also define power, voltage work conditions as inputs.

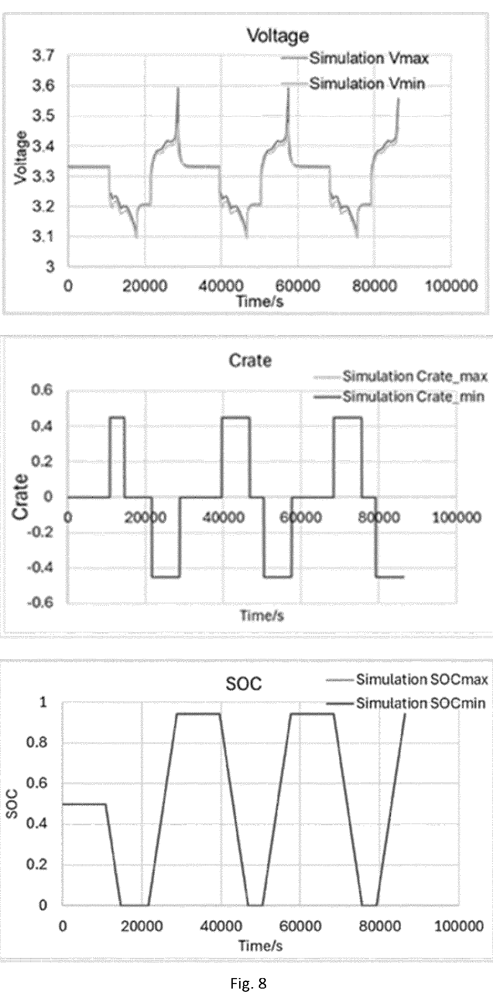

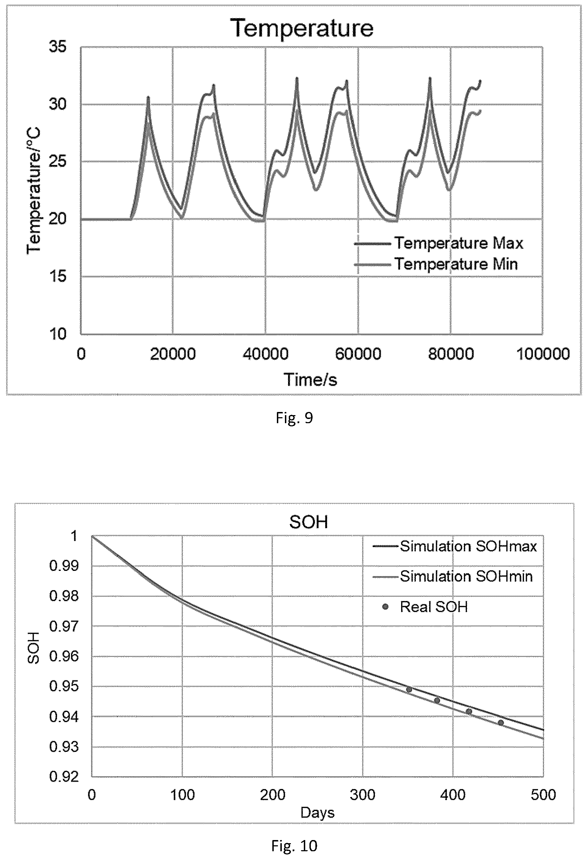

The electrical behaviors can be simulated from the two ECM model units in the ECM model. The simulated electrical behaviors may include voltages, SOC, Crate, DOD (depth of discharge), power, efficiency and so on. As an example, the outputs are shown in Figure 8. The different graphs of fig. 8 show (from top to bottom) voltage, SOC, and Crate, each over time. When the battery is fresh, the simulated max and min values of SOC and Crate could be overlapped. Electrical and thermal behaviors are the two inputs for the SOH aging model. Further, temperatures are set as inputs for the model. Fig. 9 shows an exemplary graph of temperatures over time. It shows maximum temperature and minimum temperature.

After the electrical behaviors are simulated by models and the thermal inputs are determined, the typical semi-empirical SOH aging model can be used to simulate SOH. Battery degradation happens during both operational mode (i.e. cycling aging) and storage mode (i.e. calendar aging) gradually. One typical calendar aging function and on cycling aging function are shown in below equations (1). The parameters of a, b, c, d, e, f, g, h, l, j are fitted according to different battery types The parameter t represents aging times. SOC represents state of charge. T represents temperature. Crate represents the charging or discharging current rate. DOD represents the depth of charging or discharging. EFC represents the equivalent full cycles. Equations (1): $SOHQ = 1 - σ ∗ {t}^{z}$ ${σ}_{cyc} = η ∗ f \left(T\right) ∗ f \left(Crate\right) ∗ f \left(DOD\right) ∗ f \left(SOC\right)$ ${σ}_{cal} = η ∗ f \left(T\right) ∗ f \left(SOC\right)$ $SOH \left(cal\right) = 1 - \left(a∗SOC+b\right) ∗ exp \left(\frac{c}{T + 273.15}\right) ∗ {t}^{d}$ $\begin{matrix}SOH \left(cyc\right) = 1 - a ∗ exp \left(\frac{b}{T + 273.15}\right) ∗ exp \left(c⋅Crate\right) \\ ∗ \left(d∗{DOD}^{3}+e∗{DOD}^{2}+f∗DOD+g\right) ∗ \left(h⋅SOC+i\right) ∗ {EFC}^{j}\end{matrix}$

In the example of Li-ion batteries, they were tested to fit the parameters and the semi-empirical aging function to calculate the SOH as shown in equations (2): $SOH \left(cal\right) = 1 - \left(1.58∗SOC+1.28\right) ∗ exp \left(\frac{- 2360}{T + 273.15}\right) ∗ {t}^{0.6}$ $\begin{matrix}SOH \left(cyc\right) = 1 - 1.05 ∗ exp \left(\frac{- 1545}{T + 273.15}\right) ∗ exp \left(0.84⋅Crate\right) \\ ∗ \left(-0.07∗{DOD}^{3}+0.09∗{DOD}^{2}-0.01∗DOD+0.02\right) ∗ \left(\begin{matrix}1.18 ⋅ SOC \\ + 0.44\end{matrix}\right) ∗ {EFC}^{0.76}\end{matrix}$

Using the semi-empirical aging function, the SOH are calculated to get the minimum SOH and the maximum SOH. Fig. 10 shows the determined minimum SOH and maximum SOH. Fig. 10 also show real test data of SOH is the dots. It can be seen the measured SOH value is in the middle of the maximum and minimum SOH curves. Due to cell inconsistency, the SOH of other batteries should fluctuate around that SOH value. Hence, it is shown that this model can provide an accurate SOH range for BESS.

The disclosed method has several advantages. First: For the first time, this disclosure proposes, inter alia, the battery rack framework with two ECM model units which are embedded with effective combination of maximum and minimum ECM parameters. With the proposed model framework, the maximum and minimum value of voltage, SOC, efficiency, etc. can be obtained to cover the range of real value but with reduced computation effort. Second: The workflow of using combination of maximum and minimum electrical parameters, maximum and minimum temperatures and SOH aging models to calculate best and worst SOH in battery system, which considers the cell inconsistency in the battery system, can accurately predict SOH range for battery system. Further advantages are possible.

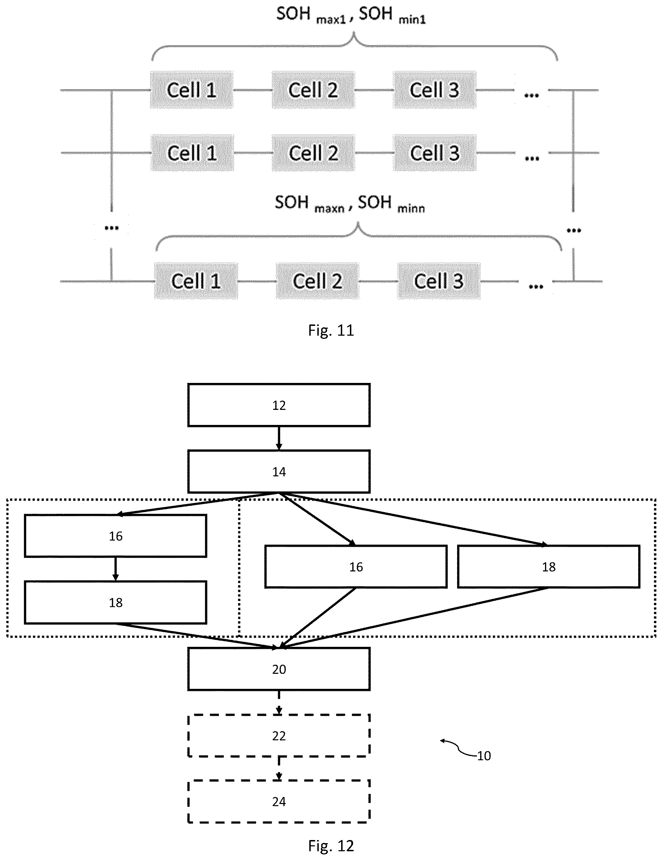

Fig. 11 shows an exemplary BESS. The BESS may be a battery module, a battery pack, a battery rack, etc., which has a plurality of battery cells connected in series and/or parallel. The BESS may further comprise a BMS (not shown).

Fig. 12 shows a flowchart showing the method 10. The method 10 is for determining a measure of degradation of state of health (SOH) of a battery energy storage system (BESS) comprising a plurality of battery cells. The method 10comprises several steps.

In step 12, a plurality of sets of electrical equivalent circuit model (ECM) parameters for the plurality of corresponding battery cells is determined. In step 14, a first temperature at the BESS and a second temperature at the BESS are determined. In step 16, a first SOH of an ECM based on a first set of ECM parameters derived from the plurality of sets of ECM parameters, and one of the first temperature and the second temperature is determined; In step 18, a second SOH of the ECM based on a second set of ECM parameters derived from the plurality of sets of ECM parameters , and one of the first temperature and the second temperature is determined. In step 20, the measure of degradation of the SOH of the BESS is determined based on the first SOH and the second SOH. In step 22, a usage time when the SOH of the BESS has deteriorated by a predetermined amount is determined based on the measure of degradation of the SOH. In step 24, the BESS is exchanged and/or renovated after the usage time.

The dotted box around steps 16 and 18 represents two exemplary embodiments. In one embodiment, the steps 16 and 18 are implemented after each other (left). In another embodiment, the steps 16 and 18 are implemented simultaneous (right). In other embodiments, one of the steps 16 and 18 may be started after the other has started but before the other has been finished. Steps 22 and 24 are represented in dashed lines as they may be optional.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

## Claims

1. A method for determining a measure of degradation of state of health, SOH, of a battery energy storage system, BESS, comprising a plurality of battery cells, the method comprising:
determining a plurality of sets of electrical equivalent circuit model, ECM, parameters for the plurality of corresponding battery cells;
determining a first temperature at the BESS and a second temperature at the BESS;
determine a first SOH of an ECM based on a first set of ECM parameters derived from the plurality of sets of ECM parameters , and one of the first temperature and the second temperature;
determine a second SOH of the ECM based on a second set of ECM parameters derived from the plurality of sets of ECM parameters, and one of the first temperature and the second temperature;
determining the measure of degradation of the SOH of the BESS based on the first SOH and the second SOH.

2. Method according to claim 1, wherein the first SOH is a minimum SOH, the second SOH is a maximum SOH, the first temperature is a minimum temperature and the second temperature is a maximum temperature.

3. Method according to claim 2, wherein the minimum temperature is a simulated lowest temperature at the BESS, a lowest temperature measured at the BESS or an average of a predefined number of strongest local minimum values of the temperature at the BESS, and wherein the maximum temperature is a simulated highest temperature at the BESS, a highest temperature measured at the BESS or an average of the predefined number of strongest local maximum values of the temperature at the BESS.

4. Method according to claim 2 or 3, wherein determining the minimum SOH is based on the first set of ECM parameters derived from the plurality of sets of ECM parameters minimizing the SOH and one of the minimum temperature and the maximum temperature which minimizes the SOH;
and wherein determining the maximum SOH is based on the second set of ECM parameters derived from the plurality of sets of ECM parameters maximizing the SOH and one of the minimum temperature and the maximum temperature which maximizes the SOH.

5. Method according to any one of the preceding claims, wherein each ECM parameter of the first set of ECM parameters deteriorates an SOH more than a corresponding ECM parameter rating of one of the plurality of battery cells; and
wherein each ECM parameter of the second set of ECM parameters deteriorates an SOH less than a corresponding ECM parameter rating of one of the plurality of battery cells;

6. Method according to any one of the preceding claims, wherein the first SOH is an SOH in a lower range of x% and the second SOH is an SOH in an upper range of x%, wherein 0 < x < 50; and/or
wherein the first temperature is a temperature in an upper range of x% of temperatures at the BESS, and the second temperature is a temperature in a lower range of x% of temperatures at the BESS.

7. Method according to any one of the preceding claims, wherein the measure of degradation is determined based on only the first SOH and the second SOH.

8. Method according to any one of the preceding claims, wherein the first set of ECM parameters and the second set of ECM parameters are comprised by the plurality of sets of ECM parameters.

9. Method according to any one of claims 1 to 7, wherein each of the first set of ECM parameters and the second set of ECM parameters comprise ECM parameters from different sets of ECM parameters of the plurality of sets of ECM parameters.

10. Method according to any one of the preceding claims, wherein the ECM parameters comprise different parameters for charging and discharging.

11. Method according to any one of the preceding claims, wherein the measure of degradation of the SOH of the BESS is a range of the SOH of the plurality of battery cells or an average of the SOH of the plurality of battery cells.

12. Method according to any one of the preceding claims, the method further comprising:
determining a usage time when the SOH of the BESS has deteriorated by a predetermined amount based on the measure of degradation of the SOH.

13. Method according to claim 12, the method further comprising:
exchanging and/or renovating the BESS after the usage time.

14. A computer program comprising instructions which, when the computer program is executed by a computer, cause the computer to carry out the method of any one of claims 1 to 12.

15. A system comprising a data processing apparatus comprising a processor configured to perform the method of any one of claims 1 to 12 and a measurement device;
wherein the measurement device is configured to determining the plurality of sets of ECM parameters for the plurality of corresponding battery cells by measuring.
